# EUROPÄISCHE PATENTANMELDUNG

(11) **EP 4 704 500 A2**
(43) Veröffentlichungstag der Anmeldung: **04.03.2026**
(21) Anmeldenummer: 25192261.3
(22) Anmeldetag: 28.07.2025
(51) Int. Cl.: H05K 5/00, H05K 5/02, H05K 7/14, H05K 7/18, G11B 33/08, F16F 1/371, F16F 3/087

(54) **TRAGGEHÄUSE ZUM AUFNEHMEN VON TECHNISCHEN AUSRÜSTUNGSGEGENSTÄNDEN**

(30) Priorität: 27.08.2024 DE 102024124460
(71) Anmelder: ZARGES GmbH, 82362 Weilheim (DE)
(72) Erfinder: Veitinger, Andreas, 82402 Seeshaupt (DE)
(74) Vertreter: Schmid, Nils T.F.

(57) **Zusammenfassung**

Die vorliegende Erfindung betrifft ein Traggehäuse zum Aufnehmen von Elektronikkomponenten, umfassend einen Gehäusekorpus, insbesondere nach dem 19"-Rastermaß gemäß DIN EN 60297-3-100 oder ElA-310-E oder nach dem halb 19"-Rastermaß, und wenigstens zwei unabhängig voneinander im Gehäusekorpus gelagerte Schwingrahmen zum Aufnehmen je wenigstens eines technischen Ausrüstungsgeräts, wobei wenigstens ein Schwingrahmen elastisch in Bezug auf den Gehäusekorpus gelagert ist.

## Beschreibung

Die vorliegende Offenbarung bezieht sich auf ein Traggehäuse zum Aufnehmen von technischen Ausrüstungsgegenständen insbesondere nach dem 19"-Rastermaß gemäß DIN EN 60297-₃-100 oder EIA-₃10-E oder nach dem halb 19"-Rastermaß. Ferner betrifft die vorliegende Erfindung ein modulares Baukastensystem für ein derartiges Traggehäuse.

Auf dem Gebiet der technischen Ausrüstungsgehäuse ist es üblich, dass diese Gehäuse standardisierte Maße wie das 19"-Rastermaß gemäß DIN EN 60297-3-100 oder ElA-310-E oder das halb 19"-Rastermaß aufweisen. Diese Gehäuse dienen zur Aufnahme und zum Schutz von technischen Ausrüstungsgegenständen wie Servern, Netzwerkgeräten und Netzwerkkomponenten, IT-Geräten, Forschungsinstrumenten, elektronischen Geräten wie Akkumulatoren und mechanischen Messgeräten. Die Ausrüstungsgehäuse bestehen typischerweise aus starren Rahmenstrukturen, die die technischen Ausrüstungsgegenstände sicher einhausen. Diese starren Konstruktionen bieten jedoch nur begrenzten Schutz gegen Vibrationen und Stöße, die während des Transports oder Betriebs auftreten können. Insbesondere in Umgebungen mit hohen mechanischen Belastungen, wie in industriellen Anwendungen oder bei mobilen Einsätzen, können Vibrationen und Stöße zu Beschädigungen der empfindlichen elektronischen Komponenten führen. Daher werden zur Reduzierung von Vibrationen und Stößen bereits sogenannte Schwingrahmen eingesetzt, die elastisch in dem starren Gehäuse gelagert sind.

Trotz dieser Maßnahmen bleibt die Herausforderung bestehen, eine optimale Balance zwischen Stabilität und Dämpfung zu finden. Ein Nachteil bestehender Ausrüstungsgehäuse besteht darin, dass diese wenig bis keine Flexibilität in Bezug auf die Lagerung und Schwingungsdämpfung der darin enthaltenen Geräte bieten. An den bekannten Gehäusen mit einem Schwingrahmen hat sich u.a. als nachteilig erwiesen, dass für das eine Schwingungssystem immer ein Kompromiss für alle darin befindlichen Komponenten bezüglich der Dämpfung gefunden werden muss.

Die CN 217 603 744 U offenbart ein gattungsgemäßes Traggehäuse mit mehreren, starr mit dem Gehäuse verbundenen Rahmen, die jeweils ein Serverelement schwingend lagern. Da die Rahmen jedoch starr mit dem Gehäuse verbunden sind, werden äußere Kräfte 1:1 in die Rahmen weitergeleitet. Auch bei der CN 217 603 744 U sind die jeweiligen Serverelemente in den jeweiligen Rahmen stets über dieselbe Lagertechnik gelagert.

Insofern besteht der Bedarf an weiter verbesserten Systemen, die eine höhere Anpassungsfähigkeit und eine effektivere Schwingungsdämpfung bieten, um für unterschiedliche Belastungen, Anforderungen und Einsatzbedingungen eine optimierte Unterbringung zu gewährleisten.

Es ist Aufgabe der vorliegenden Erfindung, die Nachteile aus dem bekannten Stand der Technik zu überwinden, insbesondere ein flexibleres und/oder anforderungsoptimiertes Traggehäuse zu schaffen.

Diese Aufgabe wird durch die Merkmale der unabhängigen Ansprüche gelöst.

Danach ist ein Traggehäuse zum Aufnehmen von technischen Ausrüstungsgegenständen, wie Servern, Netzwerkgeräten und Netzwerkkomponenten, IT-Geräten, Forschungsinstrumenten, elektronischen Geräten wie Akkumulatoren und mechanischen Messgeräten, bereitgestellt, das einen Gehäusekorpus, insbesondere nach dem 19"-Rastermaß gemäß DIN EN 60297-3-100 oder ElA-310-E oder nach dem halb 19"-Rastermaß, und wenigstens zwei unabhängig voneinander im Gehäusekorpus gelagerte Schwingrahmen zum Aufnehmen je wenigstens eines technischen Ausrüstungsgeräts aufweist. Gemäß dem ersten Aspekt der vorliegenden Erfindung ist wenigstens ein Schwingrahmen elastisch in Bezug auf den Gehäusekorpus gelagert ist. Alternativ oder zusätzlich sind die wenigstens zwei Schwingrahmen unterschiedlich in Bezug auf die Elastizität und/oder relative Schwingfähigkeit gegenüber dem Gehäusekorpus gelagert.

Der Gehäusekorpus kann als der äußere Rahmen oder das Außengehäuse verstanden werden, das die Schwingrahmen und die darin enthaltenen Ausrüstungsgegenstände umschließt. Der Schwingrahmen kann eine starre Struktur aufweisen, um die Ausrüstungsgegenstände sicher zu beherbergen und vor Beschädigungen zu schützen. Die elastische Lagerung eines Schwingrahmens bedeutet, dass dieser Schwingrahmen durch elastische Elemente wie Federn oder Dämpfer an den Gehäusekorpus angekoppelt und/oder vom Gehäusekorpus schwingungstechnisch möglichst entkoppelt ist, um einen Schutz gegen Vibrationen und Stöße zu bieten.

Ein Vorteil dieser Konstruktion besteht unter anderem in der Flexibilität bei der Aufnahme unterschiedlicher technischer Ausrüstungsgegenstände mit variierenden Anforderungen an die Dämpfung und Lagerung. Durch die unabhängige Lagerung der Schwingrahmen können verschiedene Ausrüstungsgegenstände optimal geschützt und stabilisiert werden, ohne dass Kompromisse bei der Dämpfungseffizienz eingegangen werden müssen. Ein weiterer Vorteil ist die Möglichkeit, einzelne Schwingrahmen bei Bedarf zu entnehmen oder auszutauschen, was die Wartung und den Austausch von Ausrüstungsgegenständen erleichtert.

Gemäß einer beispielhaften Ausführung ist der weitere Schwingrahmen im Gehäusekorpus so gelagert ist, dass seine relative Schwingfähigkeit gegenüber dem Gehäusekorpus infolge von auf den Gehäusekorpus einwirkenden externen Kräften geringer ist als die des anderen Schwingrahmens. Die relative Schwingfähigkeit beschreibt die Fähigkeit eines Schwingrahmens, sich relativ zum Gehäusekorpus zu bewegen oder zu schwingen, wenn externe Kräfte, wie Vibrationen oder Stöße, auf das Gehäuse einwirken. Die relative Schwingfähigkeit hängt unter anderem von der Lagerung der Schwingrahmen im Gehäusekorpus ab. Diese Lagerung kann durch verschiedene Arten von Dämpfern oder elastischen Elementen realisiert werden, die je nach Anforderung der eingebauten Geräte anpassbar sind. Der Vorteil dieser Konfiguration liegt in der Möglichkeit, unterschiedliche technische Ausrüstungsgegenstände, die unterschiedliche Anforderungen an die Schwingungsdämpfung haben, in einem einzigen Gehäusekorpus zu integrieren und mit je einem Schwingrahmen, welcher individuell elastisch gelagert ist, gegen die äußeren Kräfte zu schützen. Ein Schwingrahmen könnte beispielsweise für empfindlichere Geräte vorgesehen sein, die eine höhere Dämpfung benötigen, während der andere Schwingrahmen für weniger empfindliche oder schwerere Geräte verwendet wird, die eine geringere Dämpfung erfordern. Durch die unterschiedliche Schwingfähigkeit der Schwingrahmen kann das Traggehäuse optimal auf die spezifischen Anforderungen der eingebauten Ausrüstungsgegenstände abgestimmt werden. Dies führt zu einer verbesserten Schutzwirkung und einer höheren Betriebssicherheit der Ausrüstungsgegenstände, da jeder Ausrüstungsgegenstand in der für ihn optimalen Umgebung untergebracht wird. Zudem ermöglicht diese Ausführungsform eine flexiblere und effizientere Nutzung des verfügbaren Raums innerhalb des Traggehäuses, da verschiedene Ausrüstungsgegenstände mit unterschiedlichen Dämpfungsanforderungen gemeinsam in einem Traggehäuse untergebracht werden können.

Gemäß einer beispielhaften Ausführung ist der wenigstens eine weitere Schwingrahmen starr mit dem Gehäusekorpus verbunden oder elastisch in Bezug auf den Gehäusekorpus gelagert ist und/oder schubladenartig herausnehmbar im Gehäusekorpus gelagert. Insbesondere kann der elastisch gelagerte Schwingrahmen insbesondere schubladenartig herausnehmbar im Gehäusekorpus gelagert sein. Eine starre Verbindung bietet eine stabile und feste Montage, die besonders für schwere oder weniger empfindliche Geräte geeignet ist. Die elastische Lagerung bietet eine Dämpfung und Schutz vor Vibrationen und Stößen, was besonders für empfindliche elektronische Geräte von Vorteil ist. Die schubladenartige Herausnehmbarkeit des Schwingrahmens ermöglicht einen einfachen Zugang zu den montierten Ausrüstungsgegenständen sowie deren einfache Montage in den Gehäusekorpus. Die modulare Bauweise des Traggehäuses, die durch die schubladenartige Herausnehmbarkeit der Schwingrahmen unterstützt wird, ermöglicht zudem eine einfache Anpassung und Erweiterung des Gehäuses, um zukünftigen Anforderungen gerecht zu werden. Es ist somit auch ein Upgrade bestehender Traggehäuse möglich.

Gemäß einer beispielhaften Ausführung umfasst die elastische Lagerung mindestens einen Puffer aus elastischem Material, wie Gummi insbesondere mit einer Härte im Bereich von 40 bis 100 Shore A, einen Drahtseildämpfer oder ein funktionsäquivalentes Dämpfungselement. Gemäß einer beispielhaften Weiterbildung sind an jeder Ecke des Schwingrahmens zwei Puffer- oder Drahtseildämpferelemente vorgesehen. Die Verwendung von Gummipuffern mit einer spezifischen Härte im Bereich von 40 bis 100 Shore A ermöglicht eine Anpassung der Dämpfungseigenschaften an die spezifischen Anforderungen der eingebauten Geräte und deren Empfindlichkeit gegenüber Vibrationen und Stößen. Drahtseildämpfer bieten eine alternative Dämpfungslösung, die durch ihre Konstruktion eine hohe Energieabsorption und eine lange Lebensdauer gewährleistet. Die Anordnung von zwei Puffer- oder Drahtseildämpferelementen an jeder Ecke des Schwingrahmens sorgt für eine gleichmäßige Verteilung der Dämpfungskräfte und erhöht die Stabilität des Schwingrahmens innerhalb des Gehäusekorpus.

Gemäß einer beispielhaften Ausführung ist eine relative Schwingfähigkeit des wenigstens einen elastisch gelagerten Schwingrahmens gegenüber dem Gehäusekorpus einstellbar. Diese Schwingfähigkeit kann durch Anpassung der Härte des elastischen Lagers oder durch selektives De-/Aktivieren von zusammenwirkbaren elastischen Lagerelementen eingestellt werden. Die Anpassung der Härte des elastischen Lagers ermöglicht es, die Dämpfungseigenschaften des Schwingrahmens zu modifizieren. Das selektive De-/Aktivieren von zusammenwirkbaren elastischen Lagerelementen bietet eine zusätzliche Flexibilität, indem bestimmte Lagerelemente je nach Bedarf aktiviert oder deaktiviert werden können. Dies ermöglicht eine präzise Anpassung der Schwingfähigkeit an die spezifischen Anforderungen der im Schwingrahmen montierten Geräte. Die Einstellung der Schwingfähigkeit kann stufenlos oder stufenweise erfolgen. Ein Vorteil ist die erhöhte Flexibilität bei der Aufnahme verschiedener technischer Ausrüstungsgegenstände mit unterschiedlichen Anforderungen an die Einbauumgebung. Ein weiterer Vorteil ist die Möglichkeit, die Schutzwirkung des Gehäuses zu optimieren, indem die Dämpfungseigenschaften an die spezifischen Bedingungen angepasst werden, unter denen das Gehäuse verwendet wird.

Gemäß einer beispielhaften Ausführung umfasst die elastische Lagerung wenigstens einen elastischen Puffer, der mit einer Schnittstelle, wie einer Aufnahme, ausgestattet ist und mit einem Verhärter verbunden werden kann. Diese Verbindung ermöglicht es, die Schwingfähigkeit des elastischen Lagers stufenweise einzustellen. Durch den Verhärter kann die Dämpfungseigenschaft des Puffers angepasst werden, was eine flexible und bedarfsgerechte Einstellung der Schwingfähigkeit ermöglicht. Die Möglichkeit, die Schwingfähigkeit stufenweise einzustellen, erlaubt eine präzisere Anpassung an die spezifischen Bedürfnisse der eingebauten Ausrüstungsgegenstände. Die elastische Lagerung mit dem elastischen Puffer und der Möglichkeit zur Verbindung mit einem Verhärter bietet somit eine verbesserte Anpassungsfähigkeit und Schutzfunktion für die im Traggehäuse untergebrachten technischen Ausrüstungsgegenstände.

Gemäß einer beispielhaften Ausführung ist die elastische Lagerung durch eine Reihenschaltung von mindestens zwei insbesondere identisch ausgebildeten elastischen Pufferelementen gebildet und weist wenigstens eine de- und aktivierbare Überbrückungsklammer auf, die dazu eingerichtet ist, die Schwingfähigkeit der elastischen Lagerung durch Hinzuschalten oder Überbrücken einzelner Pufferelemente einzustellen. Die Reihenschaltung der Pufferelemente ermöglicht eine fein abgestufte Anpassung der Dämpfungseigenschaften. Die wenigstens eine Überbrückungsklammer bietet den Vorteil, dass die Dämpfungseigenschaften des Traggehäuses flexibel und schnell an die spezifischen Bedürfnisse der aufgenommenen technischen Ausrüstungsgegenstände angepasst werden können. Durch die Möglichkeit, einzelne Pufferelemente hinzuzuschalten oder zu überbrücken, kann die Schwingfähigkeit des Gehäuses präzise eingestellt werden.

Gemäß einer beispielhaften Ausführung umfasst das Traggehäuse ein, insbesondere im Querschnitt T-förmiges, Adapterstück, welches fest am Gehäusekorpus angebracht ist und zum Abstützen wenigstens zweier in einer Höheneinheitsrichtung übereinander angeordneter Schwingrahmen ausgebildet ist. Das Adapterstück kann so ausgebildet sein, dass es die Schwingrahmen, die technische Ausrüstungsgegenstände aufnehmen, stabilisiert und deren Position im Gehäusekorpus fixiert. Die T-förmige Gestaltung im Querschnitt ermöglicht eine effektive Verteilung der Kräfte, die durch die Schwingungen und Bewegungen der aufgenommenen Geräte entstehen, und trägt somit zur Stabilität und Langlebigkeit des gesamten Systems bei. Ein Vorteil dieser Konstruktion liegt in der verbesserten Modularität und Flexibilität des Traggehäuses.

Gemäß einem weiteren Aspekt der vorliegenden Erfindung, der mit den vorgehenden Aspekten und beispielhaften Ausführungen kombinierbar ist, ist ein Traggehäuse zum Aufnehmen von technischen Ausrüstungsgegenständen bereitgestellt, das einen Gehäusekorpus, insbesondere nach dem 19"-Rastermaß gemäß DIN EN 60297-3-100 oder ElA-310-E oder nach dem halb 19"-Rastermaß, wenigstens einen Schwingrahmen zum Aufnehmen je wenigstens eines technischen Ausrüstungsgeräts und ein Lager zum insbesondere elastischen Abstützen des Schwingrahmens an dem Gehäusekorpus aufweist.

Gemäß dem weiteren erfindungsgemäßen Aspekt ist das Lager derart einstellbar ausgebildet, dass die relative Schwingfähigkeit des Schwingrahmens gegenüber dem Gehäusekorpus insbesondere stufenlos einstellbar ist. Die insbesondere stufenlose Einstellbarkeit der Schwingfähigkeit bietet den Vorteil, dass die Dämpfungseigenschaften des Schwingrahmens präzise an die spezifischen Anforderungen der eingebauten Ausrüstungsgegenstände angepasst werden können. Dies ist besonders vorteilhaft, wenn Geräte mit unterschiedlichen Empfindlichkeiten gegenüber Vibrationen und Stößen in einem Gehäuse untergebracht werden müssen. Durch die Möglichkeit, die Schwingfähigkeit individuell einzustellen, kann der Schutz der Ausrüstungsgegenstände optimiert und ihre Lebensdauer verlängert werden. Zudem ermöglicht diese Flexibilität eine einfachere Anpassung des Traggehäuses an verschiedene Einsatzszenarien, sei es im stationären Betrieb oder während des Transports. Ein weiterer Vorteil der stufenlosen Einstellbarkeit ist die Verbesserung der Benutzerfreundlichkeit, da Anpassungen ohne großen Aufwand vorgenommen werden können.

Gemäß einer beispielhaften Ausführung umfasst das Traggehäuse eine Sensorik, die dazu ausgebildet ist, das Gewicht und/oder eine auf das Traggehäuse einwirkende Beschleunigung und/oder eine auf das Traggehäuse einwirkende Vibration zu erfassen, sowie eine Steuerung, die dazu ausgebildet ist, in Abhängigkeit der Sensorik, insbesondere in Abhängigkeit von von der Sensorik erfassten Daten, die relative Schwingungsfähigkeit einzustellen. Die Sensorik kann physikalische Größen wie Gewicht, Beschleunigung und Vibrationen messen. Die Steuerung kann die von der Sensorik erfassten Daten verarbeiten und daraufhin Anpassungen an der Lagerung vornehmen. Diese Anpassungen betreffen die relative Schwingungsfähigkeit, was bedeutet, dass die Dämpfungseigenschaften der Schwingrahmen in Echtzeit verändert werden können, um optimale Bedingungen für die im Gehäuse befindlichen Geräte zu gewährleisten. Ein Vorteil ist die verbesserte Anpassungsfähigkeit des Gehäuses an unterschiedliche Betriebsbedingungen. Durch die kontinuierliche Überwachung und Anpassung können die Schwingrahmen so eingestellt werden, dass sie optimale Dämpfungseigenschaften bieten, unabhängig davon, ob das Gehäuse starken Vibrationen, plötzlichen Beschleunigungen oder variierenden Gewichten ausgesetzt ist. Darüber hinaus ermöglicht die Sensorik eine präzise Diagnose und Überwachung des Zustands des Traggehäuses und der darin enthaltenen Ausrüstungsgegenstände, was die Wartung und Fehlersuche erleichtert. Die Fähigkeit, die Schwingungsfähigkeit in Echtzeit anzupassen, stellt sicher, dass das Gehäuse stets unter optimalen Bedingungen arbeitet, was insbesondere in anspruchsvollen Umgebungen wie der Militär- oder Medizintechnik von großer Bedeutung ist.

Gemäß einer beispielhaften Ausführung umfasst das Traggehäuse eine Datenbank, auf der Erfahrungswerte für das Gewicht und/oder eine auf das Traggehäuse einwirkende Beschleunigung und/oder eine auf das Traggehäuse einwirkende Vibration hinterlegt sind, sowie eine Steuerung, die dazu ausgebildet ist, in Abhängigkeit der Erfahrungswerte der Datenbank die relative Schwingungsfähigkeit einzustellen. Der Begriff "Datenbank" bezieht sich auf ein System zur Speicherung und Verwaltung von Daten, die spezifische Informationen über die physikalischen Belastungen und Eigenschaften der im Traggehäuse untergebrachten technischen Ausrüstungsgegenstände enthalten. Diese Datenbank speichert Erfahrungswerte, die aus vorherigen Messungen oder Simulationen stammen und Informationen über das Gewicht der Geräte sowie die auf das Gehäuse einwirkenden Kräfte, wie Beschleunigungen und Vibrationen, umfassen. Die Steuerung kann beispielsweise die Dämpfungseigenschaften der Schwingrahmen verändern, um die Schwingungsfähigkeit in Echtzeit zu optimieren. Durch die Speicherung und Nutzung von Erfahrungswerten können die Schwingrahmen dynamisch und präzise eingestellt werden.

Gemäß einem weiteren Aspekt der vorliegenden Erfindung, der mit den vorgehenden Aspekten und beispielhaften Ausführungen kombinierbar ist, ist ein modulares Baukastensystem für ein insbesondere gemäß einem der zuvor beschriebenen Aspekte und/oder beispielhaften Ausführungen ausgebildetes Traggehäuse zum Aufnehmen von technischen Ausrüstungsgegenständen bereitgestellt.

Das modulare Baukastensystem umfasst eine Vielzahl an Gehäusekorpussen, die sich in Bezug auf ihre Breite nach dem 19"-Rastermaß gemäß DIN EN 60297-3-100 oder ElA-310-E oder nach dem halb 19"-Rastermaß, eine Höheneinheitsabmessung und/oder eine Nenntiefe unterscheiden. Diese Gehäusekorpusse bieten somit Flexibilität in der Anpassung an verschiedene räumliche Anforderungen und ermöglichen eine optimierte Raumnutzung. Weiterhin umfasst das System eine Vielzahl von Schwingrahmen, die jeweils an die Gesamtabmessungen eines Gehäusekorpus angepasst sind und zur Aufnahme von mindestens einem technischen Ausrüstungsgerät dienen. Diese Schwingrahmen sind so konzipiert, dass sie unterschiedliche Anforderungen an die Lagerung und den Schutz der eingebauten Geräte erfüllen können, indem sie beispielsweise mit verschiedenen Dämpfungseigenschaften ausgestattet sind. Dies ermöglicht eine anforderungsoptimierte Lagerung der Geräte, wodurch die Schwingrahmen individuell auf die spezifischen Bedürfnisse der eingebauten Komponenten abgestimmt werden können. Darüber hinaus umfasst das System eine Vielzahl von Lagern, die zur Abstützung der Schwingrahmen im Gehäusekorpus dienen. Diese Lager unterscheiden sich hinsichtlich ihrer relativen elastischen Schwingfähigkeit des Schwingrahmens gegenüber dem Gehäusekorpus, ihrer Befestigungsschnittstellen zum Verbinden mit dem Gehäusekorpus und/oder dem Schwingrahmen sowie ihrem Bauraumbedarf. Diese Vielfalt an Lagern erlaubt es, die Schwingrahmen flexibel und bedarfsgerecht zu montieren, was zu einer verbesserten Vibrations- und Stoßdämpfung führt und somit den Schutz der technischen Ausrüstungsgegenstände erhöht. Zum Bilden eines Traggehäuses wird ein Gehäusekorpus mit mindestens einem Schwingrahmen und mindestens einem Lager kombiniert, was eine modulare und flexible Anpassung an verschiedene technische Anforderungen und Einsatzszenarien ermöglicht.

Gemäß einer beispielhaften Ausführung ist eine Vielzahl von Vormontageeinheiten bereitgestellt, indem jeweils ein Schwingrahmen und ein Lager vormontiert sind. In diesem Kontext bezieht sich der Begriff Baukastensystem auf ein modulares System, das aus mehreren vorgefertigten Einheiten besteht, die flexibel kombiniert und angepasst werden können, um spezifische Anforderungen zu erfüllen. Die Vormontage dieser Einheiten bedeutet, dass je ein Schwingrahmen mit den zugehörigen Lagern bereits vor der endgültigen Montage im Gehäusekorpus zusammengebaut sind. Zum einen wird der Montageprozess insgesamt vereinfacht und beschleunigt, da weniger Arbeitsschritte vor Ort erforderlich sind. Zum anderen wird die Qualität und Konsistenz der Montage verbessert, da die Vormontage unter kontrollierten Bedingungen durchgeführt werden kann. Dies reduziert das Risiko von Montagefehlern und stellt sicher, dass die Schwingrahmen und Lager optimal aufeinander abgestimmt sind. Ein weiterer Vorteil des Baukastensystems mit vormontierten Einheiten ist die erhöhte Flexibilität bei der Konfiguration des Gehäuses. Da die Schwingrahmen und Lager bereits vormontiert sind, können sie je nach den spezifischen Anforderungen der einzubauenden technischen Ausrüstungsgegenstände leicht ausgetauscht oder neu angeordnet werden.

Bevorzugte Ausführungen sind in den Unteransprüchen gegeben.

Im Folgenden werden weitere Eigenschaften, Merkmale und Vorteile der Erfindung mittels Beschreibung bevorzugter Ausführungen der Erfindung anhand der beiliegenden beispielhaften Zeichnungen deutlich, in denen zeigen:
- Figur 1: eine schematische Frontansicht einer beispielhaften Ausführung eines erfindungsgemäßen Traggehäuses mit zwei Schwingrahmen;
- Figur 2: eine schematische seitliche Frontansicht einer beispielhaften Ausführung eines erfindungsgemäßen Traggehäuses mit zwei Schwingrahmen;
- Figur 3: eine schematische seitliche Frontansicht einer beispielhaften Ausführung eines erfindungsgemäßen Traggehäuses mit drei Schwingrahmen;
- Figur 4: eine schematische seitliche Frontansicht einer beispielhaften Ausführung eines Schwingrahmens mit acht Puffern;
- Figur 5: eine schematische seitliche Frontansicht einer weiteren beispielhaften Ausführung eines Schwingrahmens mit 16 Puffern;
- Figur 6: eine schematische Detailansicht einer beispielhaften Ausführung der Schnittstelle zwischen Gehäusekorpus und Schwingrahmen mittels eines Lagerelements;
- Figur 7: eine schematische Detailansicht einer beispielhaften Ausführung des Adapterstücks;
- Figur 8: eine schematische Detailansicht einer beispielhaften Ausführung des Verriegelungsmechanismus eines herausnehmbaren Schwingrahmens;
- Figur 9: eine schematische Detailansicht einer beispielhaften Ausführung der Schnittstelle zwischen Gehäusekorpus und Schwingrahmen mittels eines einstellbaren Pufferelements;
- Figur 10a: eine schematische Detailansicht einer weiteren beispielhaften Ausführung der Schnittstelle zwischen Gehäusekorpus und Schwingrahmen mittels eines weiteren einstellbaren Pufferelements in einem ersten Betriebszustand;
- Figur 10b: eine schematische Detailansicht einer weiteren beispielhaften Ausführung der Schnittstelle zwischen Gehäusekorpus und Schwingrahmen mittels eines weiteren einstellbaren Pufferelements in einem zweiten Betriebszustand;
- Figur 11a: eine schematische Darstellung einer beispielhaften Ausführung einer Reihenschaltung von Puffern in einem ersten Betriebszustand;
- Figur 11b: eine schematische Darstellung einer beispielhaften Ausführung einer Reihenschaltung von Puffern in einem zweiten Betriebszustand; und
- Figur 12: eine schematische Darstellung einer weiteren beispielhaften Ausführung einer Reihenschaltung von Puffern.

In der folgenden Beschreibung beispielhafter Ausführungen ist ein erfindungsgemäßes Traggehäuse im Allgemeinen mit der Bezugsziffer 1 versehen. Gleiche bzw. ähnliche Komponenten werden mit gleichen bzw. ähnlichen Bezugsziffern versehen.

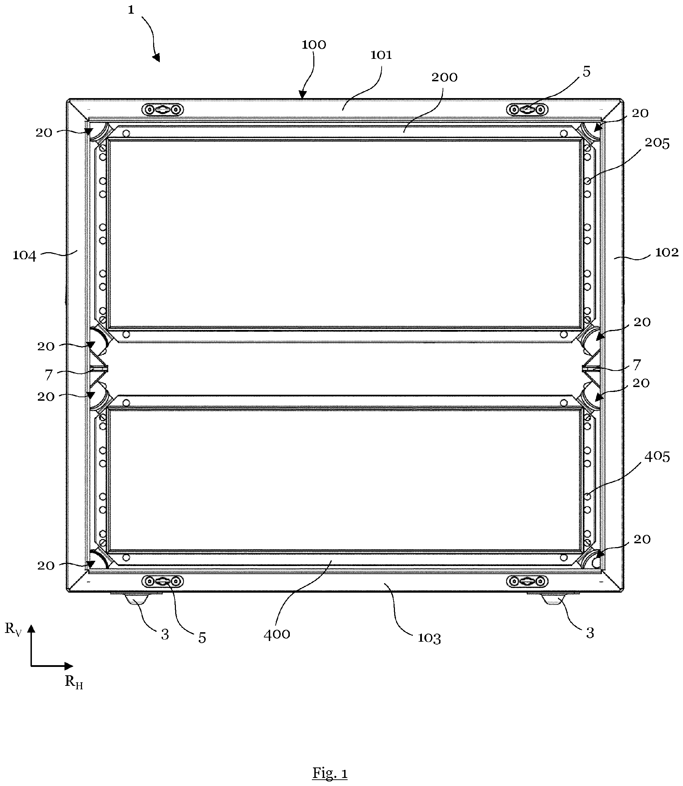

In Figur 1 ist eine Frontansicht eines geöffneten Traggehäuses 1 gezeigt. Im Allgemeinen umfasst das Traggehäuse einen Gehäusekorpus 100, der insbesondere vier Wandelementen 101, 102, 103, 104 umfasst, sowie zwei nicht dargestellte Verschlussdeckel 15, die jeweils lösbar an Vorder- und Rückseite des Gehäusekorpus 100 angebracht werden können. Der in Figur 1 dargestellte Gehäusekorpus 100 weist vier rechtwinklig miteinander verbundenen Wandelementen 101 bis 104 auf, jedoch ist auch eine Ausführung aus einem einzelnen Element denkbar. Dabei bildet das Wandelement 101 die Oberseite, das Wandelement 103 die Unterseite und die Wandelemente 102 und 104 jeweils eine Seitenwand des Gehäusekorpus 100. Die Wände 101 bis 104 sind derart miteinander verbunden, dass sie einen Korpus bilden, der zu einer Vorder- und Rückseite hin geöffnet ist und in dem die Schwingrahmen 200 und 400 angeordnet sind. An der Unterseite des Gehäusekorpus 100, also des Wandelements 103, sind Standfüße 3 angebracht, die einen sicheren Stand des gesamten Traggehäuses 1 gewährleisten.

Die Wandelemente 101 und 103 des Gehäusekorpus weisen an ihren Stirnflächen jeweils zwei Verschlussaussparungen 5 and der Front- sowie analog der Rückseite des Gehäusekorpus 100 auf. Diese dienen dazu jeweils einen nicht gezeigten Verschlussdeckel an Front- und Rückseite mittels eines Drehverschlusses an dem Gehäusekorpus 100 zu befestigen und diesen dadurch zu verschließen.

In den gezeigten Ausführungen der Figuren 1 bis 3 sind die Wandelemente 101, 102, 103, 104 sowie die Verschlussdeckel 15 aus Metall, insbesondere aus Aluminium, hergestellt. Aluminium ist besonders vorteilhaft, da es sowohl eine große Stabilität gegenüber mechanischen Einflüssen wie Schlägen oder Stößen aufweist, korrosionsbeständig ist und leicht. Zudem bietet Aluminium auch einen Schutz gegenüber elektromagnetischen Einflüssen wie elektromagnetischer Strahlung. Es ist denkbar, dass der Gehäusekorpus 100 aus einem anderen Metall gefertigt ist, wie zum Beispiel Edelstahl oder aus anderen Materialien wie GFK, CFK, Kunststoff oder Holz.

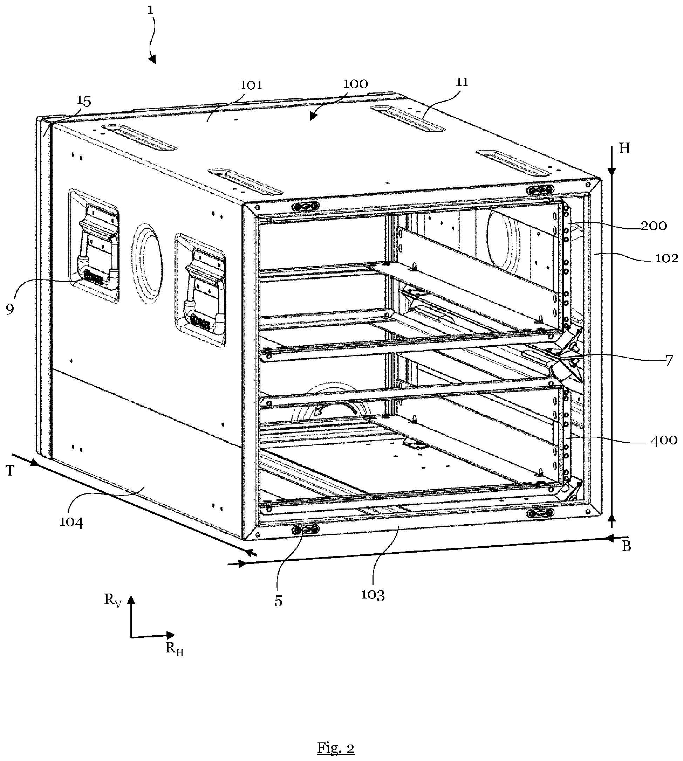

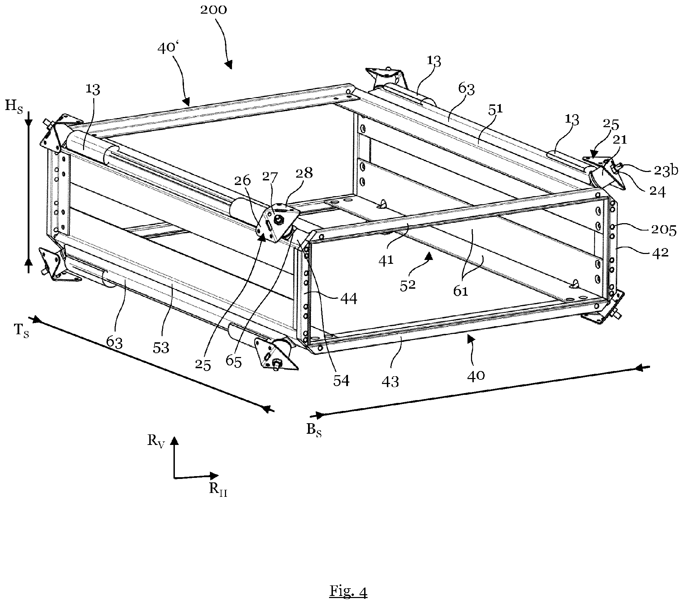

Innerhalb des Gehäusekorpus 100 sind zwei Schwingrahmen 200 und 400 angeordnet. Der Aufbau der Schwingrahmen 200, 400 ist in Figur 4 detaillierter gezeigt. Schwingrahmen 200 bildet im Gehäusekorpus 100 den oberen Schwingrahmen und Schwingrahmen 400 den unteren. Die beiden Schwingrahmen 200 und 400 weisen jeweils eine Breite B_{S} entsprechend dem 19"-Rastermaß, dem halb 19"-Rastermaß auf, um, hier nicht gezeigte technische Ausrüstungsgegenstände aufnehmen zu können. Zur Befestigung der technischen Ausrüstungsgegenstände an bzw. in den Schwingrahmen 200, 400 weisen diese entsprechende Befestigungslöcher 205, 405 auf. Die Dimensionierung des Gehäusekorpus 100 ist derart, dass die Schwingrahmen 200, 400 in jede Richtung einen Abstand vom Gehäusekorpus 1 aufweisen, sodass die Schwingrahmen 200, 400 bei auftretenden Vibrationen, Stößen oder Schlägen ein ausreichendes Schwingspiel haben, um nicht gegen den Gehäusekorpus zu schlagen. Um im Falle einer Überlastung der unten beschriebenen Lagerelemente 20 eine Beschädigung der technischen Ausrüstungskomponenten zu vermeiden, sind an den Schwingrahmen zusätzliche Anschlagsdämpfer 13 angebracht, die in Figur 2 dargestellt sind.

Die Schwingrahmen 200, 400 sind über Lagerelemente 20 mit dem Gehäusekorpus 100 verbunden. Die Lagerelemente 20 sind an den Schwingrahmen 200, 400 befestigt und gemäß der beispielhaft dargestellten Ausführung in einem Winkel von 45 Grad gegenüber der horizontalen Richtung R_{H} bzw. vertikalen Richtung R_{V} des Traggehäuses 1 geneigt, wobei klar ist, dass der Winkel dämpfer- und/oder traggehäuseabhängig angepasst werden kann. Die Lagerelemente 20 sind unter Bezugnahme von Figur 4 detaillierter beschrieben.

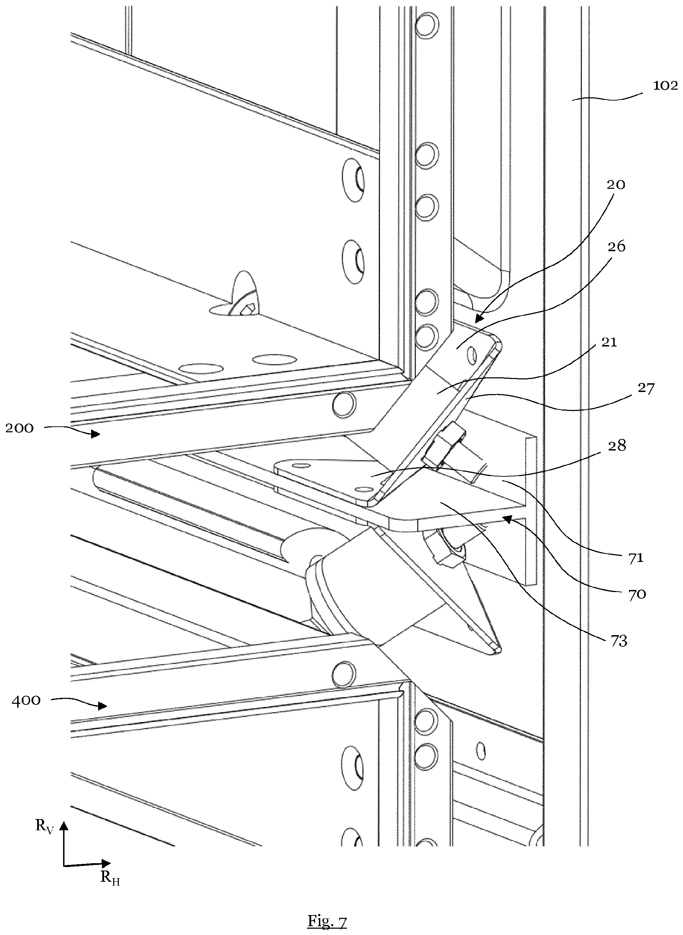

In vertikaler Richtung R_{V} sind die unteren Lagerelemente 20 des oberen Schwingrahmens 200 und die oberen Lagerelemente 20 des unteren Schwingrahmens 400 über ein Adapterstück 70 mit den Wandelementen 102 und 104 des Gehäusekorpus 100 verbunden. Das Adapterstück 70 ist gemäß der beispielhaften Ausführung im Querschnitt T-förmig ausgebildet, wobei auch andere Formen denkbar sind, und derart angeordnet, dass ein erster Abschnitt 71 parallel zu den Seitenwänden 102, 104 des Gehäusekorpus 100 ausgerichtet ist und mit diesen fest verbunden ist, und der zweite, dazu senkrechte Abschnitt 73 in das Innere des Gehäusekorpus 100 ragt und eine horizontale Fläche bildet. Das Adapterstück 70 ist detailliert in Figur 7 dargestellt.

Die beiden Schwingrahmen 200, 400 sind unabhängig voneinander schwingend gelagert. Dies bedeutet, dass sie unabhängig voneinander am Gehäusekorpus 100 gelagert und gedämpft sind und keinen Einfluss aufeinander ausüben. Es besteht auch die Möglichkeit, dass nur einer der Schwingrahmen 200, 400 gedämpft also schwingend gelagert ist und der entsprechend andere Schwingrahmen eine starre Verbindung zum Gehäusekorpus 100 aufweist, diese Konfiguration ist in den Figuren nicht dargestellt.

Bezugnehmend auf Figur 2 ist eine seitliche Frontansicht des in Figur 1 dargestellten Traggehäuses abgebildet. In Figur 2 ist zu erkennen, dass das Traggehäuse 1 eine Nennbreite B, eine Nenntiefe T, sowie eine Nennhöhe H aufweist. Die Nennhöhe H erstreckt sich entlang der vertikalen Richtung R_{V}, Nennbreite B und Nenntiefe T entlang der horizontalen Richtung R_{H} des Traggehäuses 1. Die Öffnung des Gehäusekorpus 100 ist durch die Nennbreite B und Nennhöhe H, je abzüglich der Dicke der Wandelemente 102 und 104 sowie 101 und 103 definiert.

Die Seitenwandelemente 102 und 104 weisen an deren Außenseite je zwei Tragegriffe 9 auf, die einen vereinfachten Transport des Traggehäuses 1 gewährleisten. Das obere Wandelement 101 ist an dessen Außenseite mit vier Versenkungen 11 versehen, die die Standfüße 3 eines weiteren Traggehäuses aufnehmen können, um ein sicheres Stapeln von Traggehäusen 1 zu ermöglichen.

An dem in Figur 2 dargestellten Traggehäuse 1 ist an dessen Rückseite ein Verschlussdeckel 15 angebracht.

Die beiden T-förmige Adapterstücke 70 erstrecken sich in Figur 2 über die gesamte Nenntiefe T des Gehäusekorpus 100, allerdings ist auch denkbar, die Adapterstücke 70 zweiteilig auszuführen, sodass sich jedes dieser Stücke über weniger als 50% der Nenntiefe T des Gehäusekorpus 100 erstreckt, sodass in dem in Figur 2 gezeigten Ausführungsbeispiel vier Adapterstücke 70 zum Einsatz kämen.

Figur 2 zeigt eine Ausführung des Traggehäuses 1 mit zwei elastisch gelagerten Schwingrahmen 200, 400 unterschiedlicher Höhe. Es versteht sich, dass die Lagerelemente 20 der beiden Schwingrahmen 200, 400 nicht die gleichen elastischen Eigenschaften aufweisen müssen Es ist denkbar, dass ein Schwingahmen mit Lagerelementen größerer Elastizität gelagert ist als der andere, abhängig von den gewünschten Schwingungsdämpfungseigenschaften für die jeweiligen Schwingrahmen 200, 400.

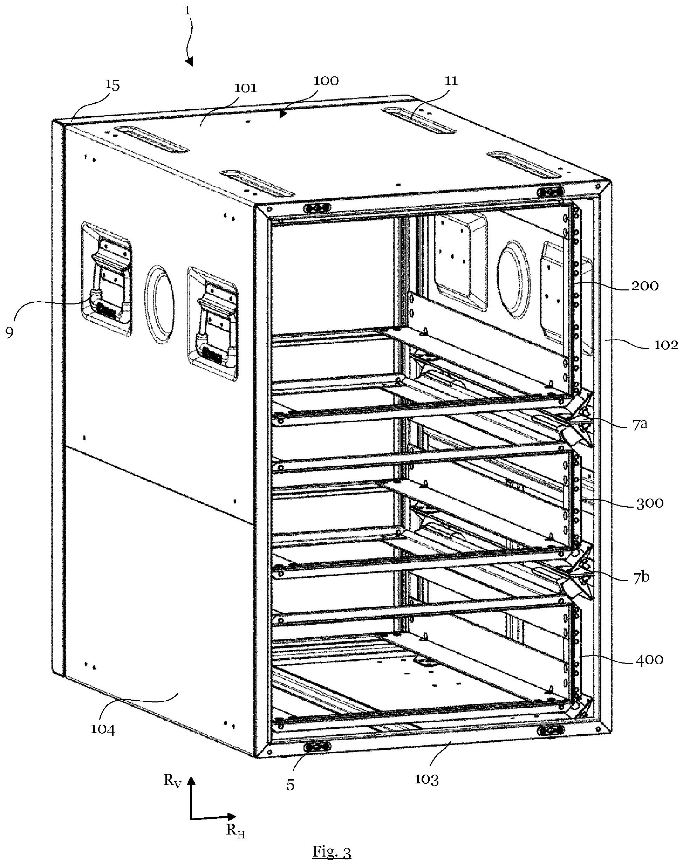

In Figur 3 ist eine weitere Ausführung eines Traggehäuses 1 mit drei Schwingrahmen 200, 300, 400 dargestellt. Der obere Schwingrahmen 200 und der mittlere Schwingrahmen 300 sind über ein gemeinsames Adapterstückpaar 70a mit den Wandelementen 102 und 104 verbunden und der mittlere Schwingrahmen 300 und der untere Schwingrahmen 400 über ein gemeinsames Adapterstückpaar 70b.

In Figur 4 ist der detaillierte Aufbau eines Schwingrahmens 200 inklusive Lagerelementen 20 gezeigt. Der Schwingrahmen 200 weist grundsätzlich 12 Profilstäbe auf, wobei je vier Profilstäbe 41, 42, 43, 44 zwei rechteckige Stirnseiten 40, 40' des Schwingrahmens 200 bilden. Die Stirnseiten 40, 40' dienen als Montageöffnungen, in die die aufzunehmenden technischen Ausrüstungsgegenstände in den Schwingrahmen 200 eingeschoben und platziert werden. Die Profilstäbe 41, 42, 43, 44 weisen Befestigungslöcher 205 auf, die dazu dienen, die aufzunehmenden technischen Ausrüstungsgegenstände mit dem Schwingrahmen 200 zu verbinden. Die Länge der Profilstäbe 42 und 44 definieren die Höhe H_{S} des Schwingrahmens 200, die Profilstäbe 41 und 43 die Breite B_{S} des Schwingrahmens 200. Da vornehmlich Elektrokomponenten wie Server in den Schwingrahmen 200 eingebaut werden sollen, weist der Schwingrahmen 200 meist eine Breite entsprechend dem 19"-Rastermaß oder dem halb 19"-Rastermaß auf, ist jedoch nicht darauf beschränkt.

Beim 19"-Rastermaß beträgt die Breite B_{S}, gemessen von der Innenkante des Profilstabs 44 zur Innenkante des Profilstabs 42, 450 mm und die Mittelpunkte der Befestigungslöcher 205, die jeweils and den beiden Profilstäben 44 und 42 an der gleichen Position in vertikaler Richtung R_{V} angeordnet sind, sind 465 mm voneinander beabstandet.

Beim halb 19"-Rastermaß beträgt die Breite B_{S}, gemessen von der Innenkante des Profilstabs 44 zur Innenkante des Profilstabs 42, 237 mm und die Mittelpunkte der Befestigungslöcher 205, die jeweils and den beiden Profilstäben 44 und 42 an der gleichen Position in vertikaler Richtung R_{V} angeordnet sind, sind 251,5 mm voneinander beabstandet.

Die Stirnseiten 40, 40' weisen im Querschnitt eine rechteckige Kontur auf, jedoch sind die vier Ecken dieser an der Außenseite in einem Winkel von 45 Grad abgeschrägt. Somit ergibt sich eine rechteckige Innenkontur und eine achteckige Außenkontur der Stirnseiten 40, 40'.

Die Profilstäbe 51, 52, 53, 54 verbinden die beiden Stirnseiten 40, 40' an deren Ecken zu einem quaderförmigen Schwingrahmen 200. Somit ist die Tiefe Ts des Schwingrahmens 200 durch die Länge der Profilstäbe 51, 52, 53, 54 definiert. Die die Stirnseiten 40, 40' verbindenden Profilstäbe 51, 52, 53, 54 weisen entsprechend der abgeschrägten Ecken der Außenkontur der Stirnseiten 40, 40' eine entsprechende Abschrägung auf, sodass die Profilstäbe 51, 52, 53, 54 in einer Draufsicht frontal auf eine der Stirnseiten 40, 40' des Schwingrahmens 200, nicht über die Kontur dieser hinausstehen (siehe Figur 1).

Zur Erhöhung der Stabilität entlang der Tiefe des Schwingrahmens 200 sind parallel zu den Profilstäben 51, 52, 53, 54 insgesamt acht Versteifungselemente 61 an den die Stirnseiten 40, 40' bildenden Profilen 41, 42, 43, 44 angebracht. Dabei sind je zwei Versteifungselemente 61 auf Stoß an jeder Ecke der Stirnseiten 40, 40' mit den Profilen 41, 42, 43, bzw. 44 verbunden. Die Versteifungselemente 61 weisen eine größere Breite als Dicke auf und dienen so auch als Stützflächen für die im Schwingrahmen 200 aufzunehmenden technischen Ausrüstungsgegenstände sowohl in vertikaler Richtung R_{V} als auch in horizontaler Richtung R_{H}.

Auf jedem der Profilstäbe 51, 52, 53, 54 ist jeweils an deren vom Schwingrahmen 200 nach außen weisenden, abgeschrägten Fläche ein weiterer Profilstab 63 verbunden. An diesen Profilstäben 63 sind je zwei Anschlagsdämpfer 13 angebracht. Die Profilstäbe 63 haben eine geringere Längserstreckung als die Profilstäbe 51, 52, 53, 54 und weisen an deren Ende eine um 45 Grad abgeschrägte Lagermontagefläche 65 auf. An dieser Lagermontagefläche 65 ist jeweils ein Lagerelement 20 befestigt. Insgesamt ist der Schwingrahmen 200 mittels acht Lagerelementen 20 im Gehäusekorpus 100 gelagert. Durch die abgeschrägten Lagermontageflächen 65 der Profilstäbe 63 in Kombination mit nach den außen abgeschrägten Profilstäben 51, 52, 53, 54 ergibt sich, dass jedes der Lagerelemente 20 gegenüber allen drei Raumachsen um 45 Grad geneigt ist. Dementsprechend kann jedes der Lagerelemente 20 Kräfte in jede Raumrichtung absorbieren. Das hat den Vorteil, dass die in dem Schwingrahmen 200 montierten technischen Ausrüstungsgegenstände gegen Vibrationen, Stöße und Schläge aller Art und Richtung geschützt sind.

Die Anschlagsdämpfer 13 weisen eine halbzylindrische Form auf und bestehen vorzugsweise aus einem elastischen Material wie Gummi. Sie sind derart an den Profilstäben 63 angebracht, dass sie im Falle einer Erschütterung des Traggehäuses, die von den Lagerelementen 20 nicht ausreichend absorbiert bzw. gedämpft werden kann in Kontakt mit den Wandelementen 101, 102, 103 oder 104 des Gehäusekorpus kommen und eine zusätzliche Dämpfung erzeugen.

Vorzugsweise sind alle oben genannten Profilstäbe (41, 42, 43, 44, 51, 52, 53, 54, 63) sowie die Versteifungselemente 61 aus Aluminium gefertigt, um einen möglichst stabilen und gleichzeitig leichten Schwingrahmen 200 zu bilden, damit die Lagerelemente 20 durch das Eigengewicht des Schwingrahmens 200 möglichst geringfügig belastet werden. Allerdings ist auch eine Fertigung aus Kunststoff, anderen Metallen oder Materialien denkbar.

Die in Figur 4 gezeigten Lagerelemente 20 umfassen je zwei Elemente, ein Pufferelement 21, sowie ein Gehäuseverbindungselement 25. Das Pufferelement 21 ist ein zylinderförmiger Gummipuffer, an dessen Stirnflächen Gewindestifte 23a, 23b angebracht sind, alternativ sind Gewindebohrungen vorgesehen oder andere Befestigungsmittel. Einer der beiden Gewindestifte 23a ist an der Lagermontagefläche 65 des Schwingrahmens 200 angeschraubt, und der gegenüberliegende Gewindestift 23b mittels einer Mutter 24 an dem Gehäuseverbindungselement 25 angebracht. Der Gewindestift 23a ist in den Figuren verdeckt. Das Gehäuseverbindungselement 25 ist ein rechteckiges Flachteil, das derart gebogen ist, dass drei zueinander abgewinkelte dreieckige Flächen 26, 27, 28 ausgebildet sind. Unter Flachteil ist ein Element zu verstehen, dessen Länge und Breite um ein Vielfaches größer ist als dessen Dicke. Die Flächen sind derart gewinkelt, dass die beiden äußeren Flächen 26 und 28 gegenüber der mittleren Fläche 27 um je 135 Grad abgewinkelt sind, sodass die Flächen 26 und 28 zueinander senkrecht liegen. Das Pufferelement 21 ist an der mittleren Fläche 27 über den Gewindestift 23b und einer Mutter 24 angebracht und steht senkrecht auf dieser. Dies ermöglicht es, dass im Einbauzustand des Schwingrahmens 200 im Gehäusekorpus 100 die Fläche 26 des Gehäuseverbindungselements 25 parallel zu einem der Seitenwandelemente 102, 104 liegt und die Fläche 28 des gleichen Gehäuseverbindungselements 25 parallel entweder zum oberen oder unteren Wandelement 101, 103 oder parallel zum horizontalen zweiten Abschnitt 73 des T-förmigen Adapterstücks 70 liegt, währen das Pufferelement 21 um 45 Grad gegenüber allen Raumachsen geneigt ist.

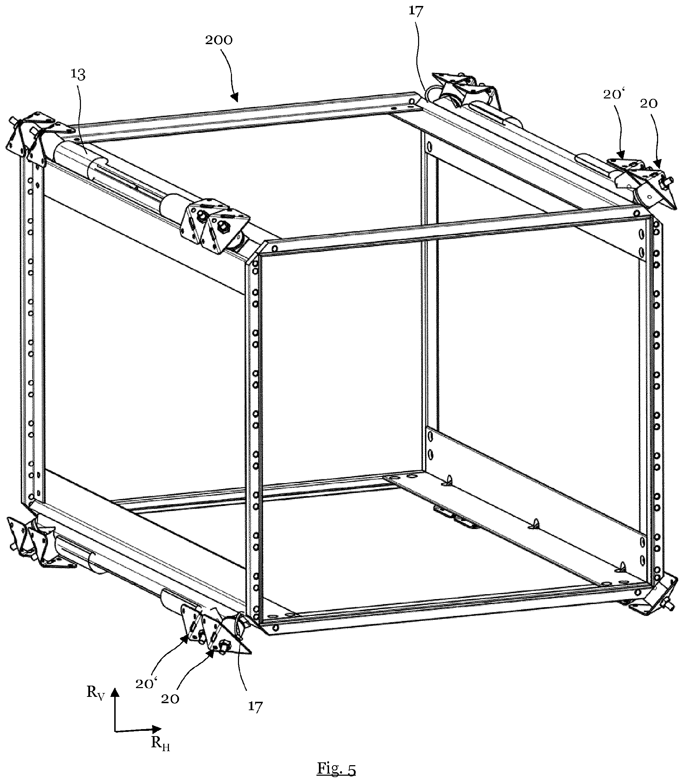

Figur 5 zeigt eine weitere Ausführung eines Schwingrahmens 200, der anstatt acht Lagerelementen 20, wie in Figur 4 gezeigt, 16 Lagerelemente 20, 20' aufweist. Neben den bestehenden Lagerelementen 20 ist in dieser Ausführung jeweils in Tiefenrichtung nach innen versetzt ein Zusatzlagerelement 20' am Schwingrahmen befestigt. Somit sind acht Paare von Lagerelementen 20, 20' am Schwingrahmen befestigt. Der Dämpfungsgrad kann somit erhöht, bzw. verändert werden, insbesondere ist die Kombination unterschiedlicher Härtegrade des Dämpfers möglich.

Ferner ist in Figur 5 ein Erdungskabel 17 gezeigt. Das Erdungskabel 17 verbindet den Schwingrahmen elektrisch leitend mit dem Gehäuseverbindungselement 25 und somit mit dem Gehäusekorpus 100. Dies sorgt für eine optimierte Erdung der zu transportierenden technischen Ausrüstungsgegenstände und gewährleistet deren sichere und störungsfreie Funktion.

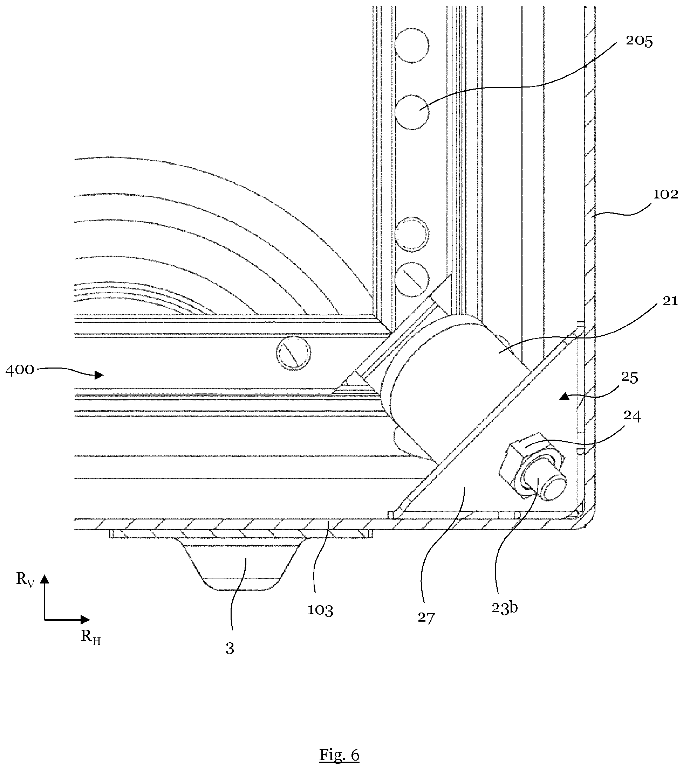

In Figur 6 ist eine detaillierte Ansicht des Lagerelements 20 im Einbauzustand des Schwingrahmens 400 im Gehäusekorpus 100 gezeigt. Es ist deutlich zu erkennen, dass das Gehäuseverbindungselement 25 des Lagerelements 20 derart geformt ist, dass eine Fläche 26 parallel zum Seitenwandelement 102 liegt und eine Fläche 28 (siehe Figur 7) parallel zum unteren Wandelement 103 liegt, sowie dass die mittlere Fläche 27 im 45 Grad Winkel zu den beiden Flächen 26, 28 geneigt ist. Das Pufferelement 21 ragt mit dem Gewindestift 23b durch das Gehäuseverbindungselement 25 durch eine verdeckte Aussparung hindurch und ist von der Gegenseite mittels der Mutter 24 gesichert. Durch die lösbare Verbindung des Pufferelements 21 bzw. des gesamten Lagerelements 20 ist ein Austauschen der Lagerelemente 20 im Traggehäuse 1 möglich und das Schwingungs- bzw. Dämpfungsverhalten des Schwingrahmens 200 kann je nach Bedarf angepasst werden.

Figur 7 zeigt eine Detailansicht des T-förmigen Adapterstücks 70 im Einbauzustand der Schwingrahmen 200, 400 im Gehäusekorpus 100. Das Adapterstück 70 weist zwei zueinander senkrecht stehende Abschnitte 71 und 73 auf. Der erste Abschnitt 71 liegt im Einbauzustand parallel zum Seitenwandelement 102 und ist mit diesem verbunden. Der dazu senkrecht stehende zweite Abschnitt 73 ragt horizontal bzw. parallel zum oberen und unteren Wandelement 101, 103 in das Innere des Gehäusekorpus 100. Dabei bildet der zweite Abschnitt 73 die Abstützung für die Lagerelemente 20 des oberen und unteren Schwingrahmen 200, 400. Insbesondere die Flächen 28 der Gehäuseverbindungselemente 25 sind an dem zweiten Abschnitt 73 befestigt. Das T-förmige Adapterstück 70 bildet das räumliche Trennelement zwischen zwei übereinander angeordneten Schwingrahmen 200, 400.

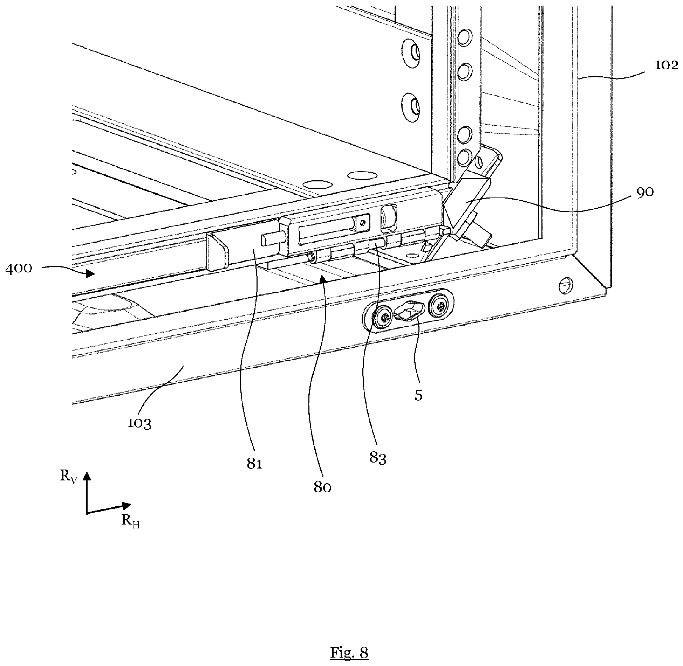

In Figur 8 ist eine Ausführungsform gezeigt, bei der Schwingrahmen 400 schubladenartig aus dem Gehäusekorpus 100 herausnehmbar ist. Insbesondere ist der Verriegelungsmechanismus 80 im Detail abgebildet.

In der in Figur 8 gezeigten Ausführung ist der Schwingrahmen 400 nicht direkt mit den Gewindestiften 23a der Pufferelemente 21 der Lagerelemente 20 verschraubt, sondern zwei in Tiefenrichtung benachbarte Lagerelemente 20 sind auf der Schwingrahmenseite mit einer gemeinsamen Führungsschiene 90 verbunden. Somit sind vier schwingend gelagerte Führungsschienen 90, die parallel zu den in Tiefenrichtung des Schwingrahmens 400 liegenden Profilstäben 51, 52, 53, 54 ausgerichtet sind, im Gehäusekorpus 100 pro Schwingrahmen vorhanden. Diese Führungsschienen 90 nehmen den Schwingrahmen 400 schubladenartig an dessen Ecken bzw. Profilstäben 51, 52, 53, 54 in Tiefenrichtung auf, sodass der Schwingrahmen 400 in den Gehäusekorpus 100 eingeschoben werden kann. Um den Schwingrahmen 400 in Tiefenrichtung zu arretieren bzw. gegen Verrutschen zu sichern, ist an einer Stirnseite des Gehäusekorpus 100 für jeden Schwingrahmen ein Verriegelungsmechanismus 80 angebracht. Dieser kann durch Verschieben des Hebels 81 hin zur Mitte des Gehäusekorpus 100 entriegelt werden und um die Schwenkachse 83 nach unten geschwenkt werden. Der Schwingrahmen 400 kann schubladenartig herausgezogen oder hineingeschoben werden, wobei die Lagerelemente 20 immer im Gehäusekorpus 100 verbleiben.

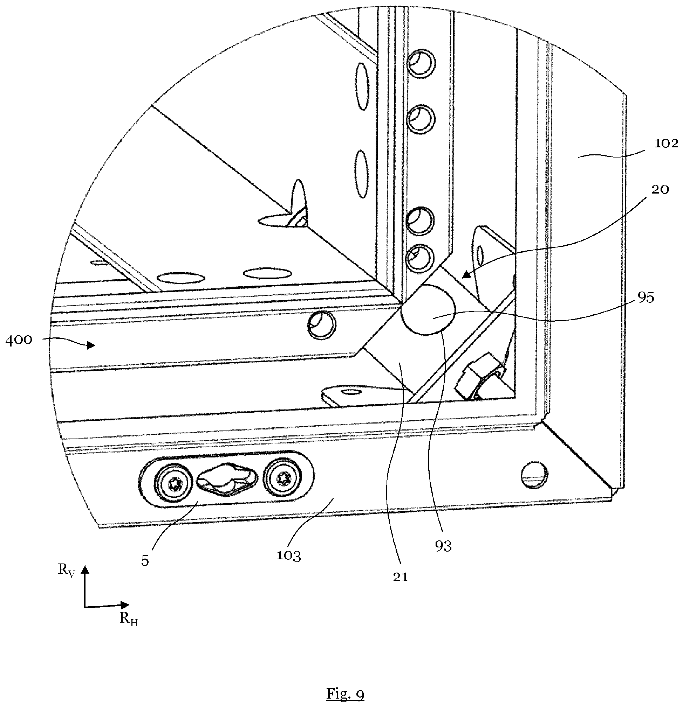

In Figur 9 ist eine Ausführungsform eines Lagerelements 20 mit veränderbarem bzw. einstellbarem Härte- bzw. Dämpfungsgrad dargestellt. Das Pufferelement 21 ist zylinderförmig geformt, mit Gewindestiften 23a, 23b oder Gewindebohrungen an den beiden Stirnseiten, um das Pufferelement 21 mit dem Schwingrahmen 400 bzw. mit dem Gehäuseverbindungselement 25 zu verbinden. Seitlich in die Mantelfläche des zylinderförmigen Pufferelements 21 ist eine Bohrung 93 eingebracht. Die Bohrung 93 kann eine vorbestimmte Tiefe aufweisen oder als Durchgangsbohrungen ausgeführt sein. Die Bohrung 93 bildet eine Schnittstelle zum Aufnehmen von daran formangepassten Verhärtern 95. Der Verhärter 95 ist ein Stift, der in die Bohrung 93 eingeführt werden kann und diese ausfüllt. Durch den Einsatz unterschiedlich harter Verhärter 95, aus Material, das weicher, gleich hart oder härter als das des Pufferelements 21 ist, in die Bohrung 93 kann der Härte- bzw. Dämpfungsgrad des Pufferelements 21 und damit des Lagerelements 20 stufenweise verändert und eingestellt werden. Alternativ kann auch kein Verhärter 95 in die Bohrung 93 eingesetzt sein, in diesem Fall ist der Härte- bzw. Dämpfungsgrad des Pufferelements 21 am geringsten.

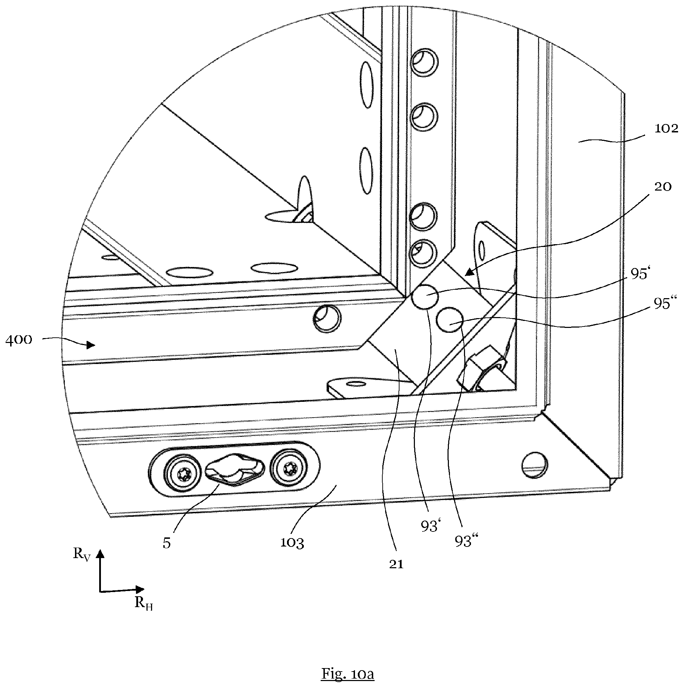

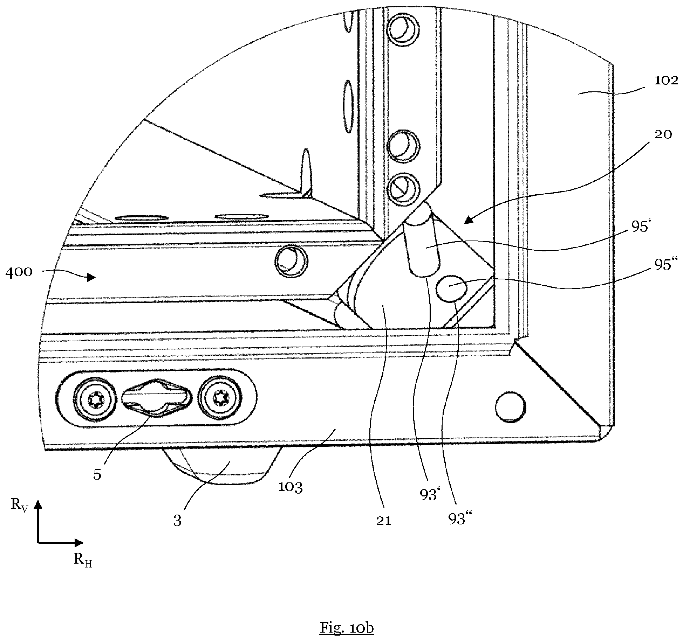

In den Figuren 10a und 10b ist eine Ausführungsform des Lagerelements 20, insbesondere des Pufferelements 21 in zwei Betriebszuständen abgebildet. In der gezeigten Ausführungsform ist der Härte- bzw. Dämpfungsgrad des Pufferelements 21 analog zur Ausführungsform in Figur 9 einstellbar bzw. veränderbar. Jedoch sind seitlich in die Mantelfläche des zylinderförmigen Pufferelements 21 zwei Bohrungen 93' und 93" eingebracht. Die Bohrungen 93', 93" können wie in der vorigen Ausführungsform (Figur 9) eine vorbestimmte Tiefe aufweisen oder als Durchgangsbohrungen ausgeführt sein. Es ist nicht notwendig, dass genau zwei Bohrungen vorgesehen sind, es kann alternativ eine Mehrzahl von Bohrungen in dem Pufferelement 21 vorgesehen sein. Analog zur Ausführung in Figur 9 sind auf die Bohrungen 93', 93" formangepasste Verhärter 95', 95" in der Form von Stiften vorgesehen, die in die Bohrungen 93', 93" eingesetzt werden. In Figur 10a ist ein Betriebszustand des Lagerelements 20 abgebildet, in dem in beiden Bohrungen 93', 93" Verhärter 95', 95" eingesetzt sind. In Figur 10b ist ein Betriebszustand des Lagerelements 20 gezeigt, bei dem ein Verhärter 95' aus der Bohrung 93' herausgezogen ist und der zweite Verhärter 95" in der zweiten Bohrung 93" eingesetzt ist. Durch die Verwendung von zwei Bohrungen 93', 93" ist die Anzahl an Kombinationsmöglichkeiten von unterschiedlichen Verhärtern 95', 95" und damit erreichten Härte- bzw. Dämpfungsgraden des Lagerelements 20 deutlich erhöht gegenüber der Ausführung aus Figur 9. In der Ausführung gemäß den Figuren 10a und 10b besteht selbstverständlich die Möglichkeit eine oder beide Bohrungen 93', 93" freizulassen, also keinen Verhärter 95', 95" einzusetzen und im ersten Fall nur in eine der Bohrungen 93', 93" einen Verhärter 95', 95" einzusetzen.

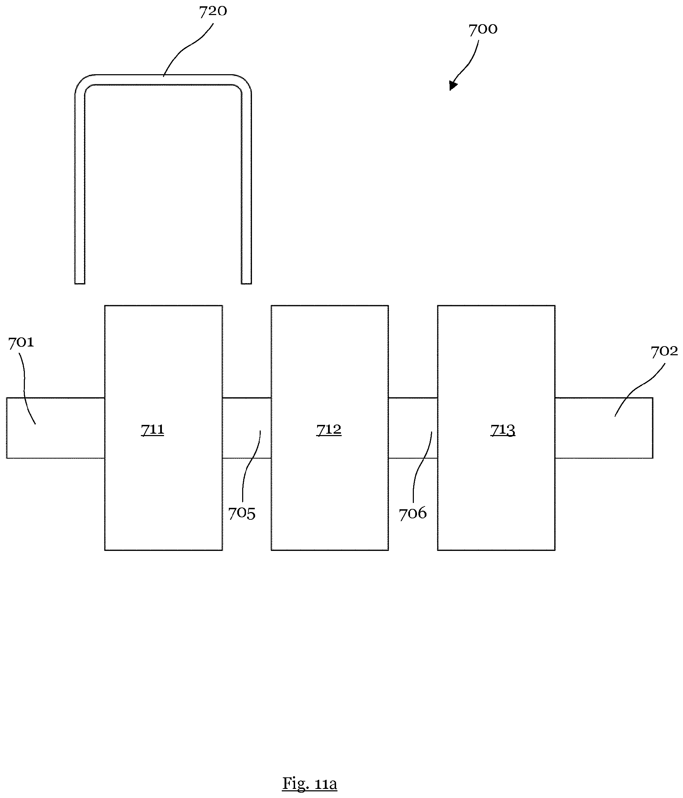

Eine weitere Ausführung eines einstellbaren bzw. veränderbaren Pufferelements 700 ist als Prinzipdarstellung in Figur 11a dargestellt. Das Pufferelement 700 weist zwei Anschlusselemente 701, 702 auf, über die das Pufferelement 700 z.B. mit Schwingrahmen 200 und Gehäuseverbindungselement 25 verbunden werden kann. Die Anschlusselemente 701, 702 können z.B. den Gewindestiften 23a, 23b des zuvor beschriebenen Pufferelements 21 entsprechen. Zwischen den beiden Anschlusselementen 701, 702 sind in der gezeigten Ausführung drei Puffer 711, 712 und 713 in Reihe geschalten und über zwei Verbindungselemente 705, 706 starr miteinander verbunden. Somit ergibt sich insgesamt für das Pufferelement 700 eine Reihenschaltung von drei einzelnen Puffern 711, 712, 713. Die einzelnen Puffer 711, 712, 713 können entweder den gleichen oder unterschiedliche Härte- bzw. Dämpfungsgrade aufweisen. Dadurch kann durch Kombination unterschiedlich harter Puffer eine Vielzahl verschiedener Dämpfungsgrade eingestellt werden. Die Ausführung des Pufferelements 700 ist nicht auf genau drei Puffer 711, 712, 713 beschränkt, sondern kann auch mit einem, zwei oder mehr als drei Puffern ausgeführt sein, die in unterschiedlichen Härten miteinander kombiniert werden können.

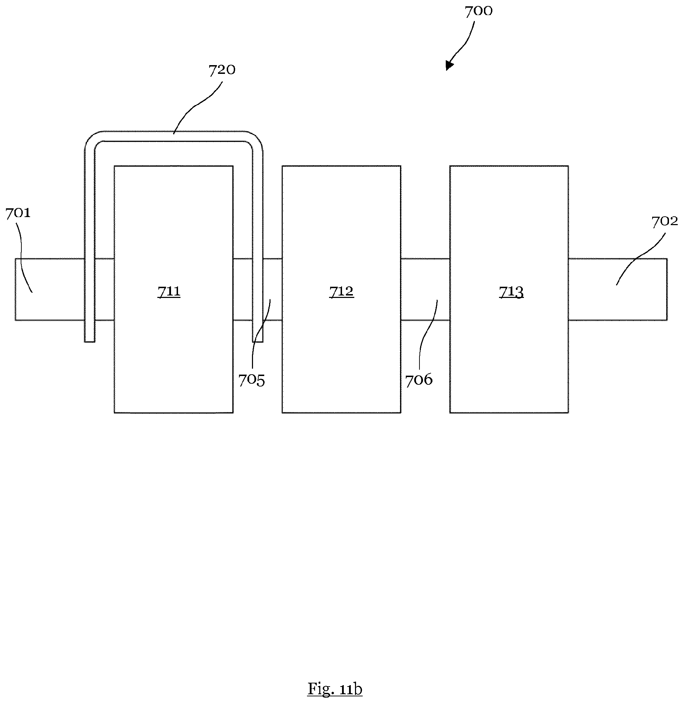

In Figur 11a ist ferner eine Überbrückungsklammer 720 in einem passiven Zustand gezeigt. Die Überbrückungsklammer 720 weist exemplarisch einen U-förmigen Querschnitt auf, kann jedoch auch anderer Gestalt sein. Die Überbrückungsklammer 720 ist derart ausgestaltet in einem aktiven Zustand einen der Puffer 711, 712, oder 713 zu überbrücken, das heißt zu deaktivieren. In Figur 11b ist die Überbrückungsklammer 720 in einem aktiven Zustand abgebildet. Im passiven Zustand der Überbrückungsklammer (Figur 11a) erfolgt der Kraftfluss durch das Pufferelement 700 vom Anschlusselement 701 über jeden der Puffer 711, 712, 713 sowie die beiden Verbindungselemente 705, 706 hin zum Anschlusselement 702. Somit trägt jeder der drei Puffer 711, 712, 713 aktiv zur Schwingungsdämpfung bei. Im aktiven Zustand der Überbrückungsklammer 720 (Figur 11b) erfolgt der Kraftfluss im Pufferelement 700 vom Anschlusselement 701 über die starre Überbrückungsklammer 720 (anstelle des Puffers 711) hin zum Verbindungselement 705 und über die Puffer 712 und 713 sowie das Verbindungselement 706 hin zum Anschlusselement 702. Somit ist im aktiven Zustand der Überbrückungsklammer 720 der Puffer 711 deaktiviert und trägt nicht zur Schwingungsdämpfung bei. Es versteht sich, dass die Überbrückungsklammer 720 alternativ auch so eingesetzt werden kann, dass sie einen der beiden anderen Puffer 712 oder 713 überbrückt. Alternativ können auch mehrere Überbrückungsklammern 720 eingesetzt werden und somit z.B. auch eine starre Verbindung zwischen den Anschlusselementen 701, 702 erzeugt werden. Durch dieses selektive Überbrücken einzelner Puffer im Pufferelement 700 mittels der Überbrückungsklammer 720 kann der Härte- bzw. Dämpfungsgrad des Pufferelements 700 leicht und präzise eingestellt bzw. verändert werden.

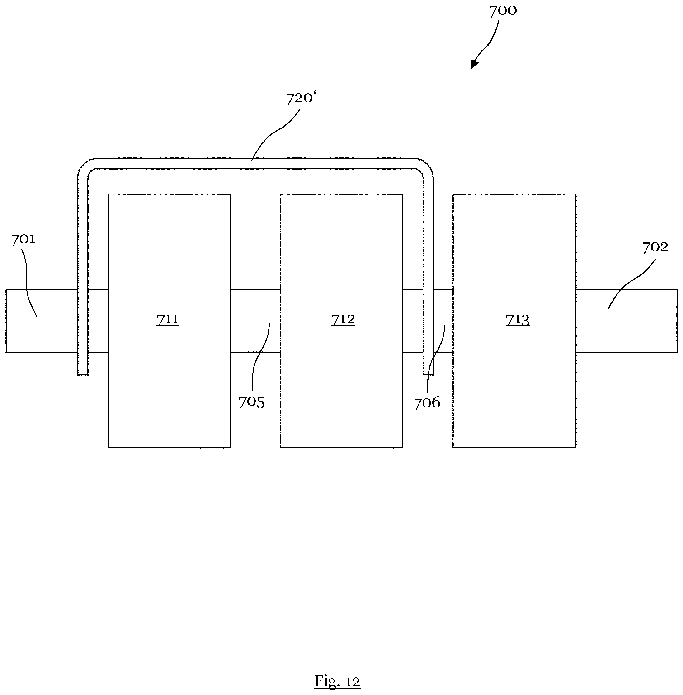

In Figur 12 ist eine alternative Ausführung der in den Figuren 11a und 11b gezeigten Überbrückungsklammer 720 gezeigt. Die Überbrückungsklammer 720' aus Figur 12 ist derart ausgestaltet, dass sie zwei Puffer 711, 712 des Pufferelements 700 simultan überbrückt. Es versteht sich, dass die Überbrückungsklammer 720' auch eingesetzt werden kann, um die Puffer 712 und 713 zu überbrücken.

Die in der vorstehenden Beschreibung, den Figuren und den Ansprüchen offenbarten Merkmale können sowohl einzeln als auch in beliebiger Kombination für die Realisierung der Erfindung in den verschiedenen Ausgestaltungen von Bedeutung sein.

### BEZUGSZEICHENLISTE:

- 1: Traggehäuse
- 3: Standfuß
- 5: Verschlussaussparung
- 9: Tragegriff
- 11: Versenkung
- 13: Anschlagsdämpfer
- 15: Verschlussdeckel
- 17: Erdungskabel
- 20: Lagerelement
- 20': Zusatzlagerelement
- 21: Pufferelement
- 23a, 23b: Gewindestift
- 24: Mutter
- 25: Gehäuseverbindungselement
- 26, 28: äußere Fläche des Gehäuseverbindungselements
- 27: mittlere Fläche des Gehäuseverbindungselements
- 40, 40': Stirnseite des Schwingrahmens
- 41, 42, 43, 44: Profilstäbe der Stirnseite
- 51, 52, 53, 54: Profilstäbe
- 61: Versteifungselement
- 63: aufgesetzte Profilstäbe
- 65: Lagermontagefläche
- 70: Adapterstück
- 70a, 70b: Adapterstückpaar
- 71: erster Abschnitt des Adapterstücks
- 73: zweiter Abschnitt des Adapterstücks
- 80: Verriegelungsmechanismus
- 81: Hebel
- 83: Schwenkachse
- 90: Führungsschiene
- 93, 93', 93": Bohrung
- 95, 95', 95": Verhärter
- 100: Gehäusekorpus
- 101: oberes Wandelement
- 102: seitliches Wandelement
- 103: unteres Wandelement
- 104: seitliches Wandelement
- 200: oberer Schwingrahmen
- 205: Befestigungsloch des oberen Schwingrahmens
- 300: mittlerer Schwingrahmen
- 400: unterer Schwingrahmen
- 405: Befestigungsloch des unteren Schwingrahmens
- 700: veränderbares Pufferelement
- 701, 702: Anschlusselement
- 705, 706: Verbindungselement
- 711, 712, 713: Puffer
- 720, 720': Überbrückungsklammer
- B: Nennbreite des Traggehäuses
- T: Nenntiefe
- H: Nennhöhe
- B_{S}: Breite des Schwingrahmens
- T_{S}: Tiefe des Schwingrahmens
- H_{S}: Höhe des Schwingrahmens
- R_{H}: Horizontale Richtung des Traggehäuses
- R_{V}: Vertikale Richtung des Traggehäuses

## Patentansprüche

1. Traggehäuse (1) zum Aufnehmen von technischen Ausrüstungsgegenständen, umfassend einen Gehäusekorpus (100), insbesondere nach dem 19"-Rastermaß gemäß DIN EN 60297-3-100 oder ElA-310-E oder nach dem halb 19"-Rastermaß, und wenigstens zwei unabhängig voneinander im Gehäusekorpus (100) gelagerte Schwingrahmen (200, 400) zum Aufnehmen je wenigstens eines technischen Ausrüstungsgeräts, wobei wenigstens ein Schwingrahmen (200) elastisch in Bezug auf den Gehäusekorpus (100) gelagert ist.

2. Traggehäuse (1) nach Anspruch 1, wobei der wenigstens eine weitere Schwingrahmen (400) derart im Gehäusekorpus gelagert ist, dass seine relative Schwingfähigkeit gegenüber dem Gehäusekorpus (100) infolge von auf den Gehäusekorpus (100) einwirkenden externen Kräften geringer als die des wenigstens einen anderen Schwingrahmens (200) ist.

3. Traggehäuse (1) nach einem der vorstehenden Ansprüche, wobei der wenigstens eine weitere Schwingrahmen (400) starr mit dem Gehäusekorpus (100) verbunden oder elastisch in Bezug auf den Gehäusekorpus (100) gelagert ist und/oder insbesondere schubladenartig herausnehmbar im Gehäusekorpus (100) gelagert ist, wobei insbesondere der wenigstens eine elastisch in Bezug auf den Gehäusekorpus (100) gelagerte Schwingrahmen (200) insbesondere schubladenartig herausnehmbar im Gehäusekorpus (100) gelagert ist.

4. Traggehäuse (1) nach einem der vorstehenden Ansprüche, wobei die elastische Lagerung (20) wenigstens einen Puffer (21) aus elastischem Material, wie Gummi insbesondere mit einer Härte im Bereich von 40 bis 100 Shore A, einen Drahtseildämpfer oder ein funktionsäquivalentes Dämpfungselement aufweist, wobei insbesondere je Ecke des Schwingrahmens (200) zwei Puffer- oder Drahtseildämpferelemente (20, 20') vorgesehen sind.

5. Traggehäuse (1) nach einem der vorstehenden Ansprüche, wobei eine relative Schwingfähigkeit des wenigstens einen elastisch gelagerten Schwingrahmens (200) gegenüber dem Gehäusekorpus (100) einstellbar ist, wobei insbesondere die relative Schwingfähigkeit durch eine Anpassung der Härte des elastischen Lagers (20) oder durch selektives De-/Aktivieren von zusammenwirkbaren elastischen Lagerelementen (20) einstellbar ist.

6. Traggehäuse (1) nach einem der vorstehenden Ansprüche, wobei die elastische Lagerung (20) wenigstens einen elastischen Puffer (21) aufweist, der eine Schnittstelle (93), wie eine Aufnahme, zum Verbinden mit einem Verhärter (95) aufweist, um die Schwingfähigkeit des elastischen Lagers (20) stufenweise einzustellen.

7. Traggehäuse (1) nach einem der vorstehenden Ansprüche, wobei die elastische Lagerung (20) durch eine Reihenschaltung von wenigstens zwei insbesondere identisch ausgebildeten elastischen Pufferelementen (700) gebildet ist und wenigstens eine de- und aktivierbare Überbrückungsklammer (720) vorgesehen ist, die dazu eingerichtet ist, die Schwingfähigkeit der elastischen Lagerung (20) durch Hinzuschalten oder Überbrücken einzelner Pufferelemente (711, 712, 713) einzustellen.

8. Traggehäuse (1) nach einem der vorstehenden Ansprüche, ferner umfassend ein, insbesondere im Querschnitt T-förmiges, Adapterstück (70), welches fest am Gehäusekorpus (100) angebracht ist und zum Abstützten wenigstens zweier in einer in Höheneinheitsrichtung übereinander angeordneter Schwingrahmen (200, 400) ausgebildet ist.

9. Traggehäuse (1), insbesondere nach einem der vorstehenden Ansprüche, zum Aufnehmen von technischen Ausrüstungsgegenständen, umfassend einen Gehäusekorpus (100), insbesondere nach dem 19"-Rastermaß gemäß DIN EN 60297-3-100 oder ElA-310-E oder nach dem halb 19"-Rastermaß, wenigstens einen Schwingrahmen (200) zum Aufnehmen je wenigstens eines technischen Ausrüstungsgeräts und ein Lager (20) zum insbesondere elastischen Abstützen des Schwingrahmens (200) an dem Gehäusekorpus (100), das derart einstellbar ausgebildet ist, dass eine relative Schwingfähigkeit des Schwingrahmens (200) gegenüber dem Gehäusekorpus (100) insbesondere stufenlos einstellbar ist.

10. Traggehäuse (1) nach Anspruch 9, ferner umfassend eine Sensorik, die dazu ausgebildet ist, das Gewicht und/oder eine auf das Traggehäuse (1) einwirkende Beschleunigung und/oder eine auf das Traggehäuse (1) einwirkende Vibration zu erfassen, und eine Steuerung, die dazu ausgebildet ist, in Abhängigkeit der Sensorik die relative Schwingungsfähigkeit einzustellen.

11. Traggehäuse (1) nach Anspruch 9 oder 10, ferner umfassend eine Datenbank, auf der Erfahrungswerte für das Gewicht und/oder eine auf das Traggehäuse (1) einwirkende Beschleunigung und/oder eine auf das Traggehäuse (1) einwirkende Vibration hinterlegt sind, und eine Steuerung, die dazu ausgebildet ist, in Abhängigkeit der Erfahrungswerte der Datenbank die relative Schwingungsfähigkeit einzustellen.

12. Modulares Baukastensystem für ein insbesondere nach einem der vorstehenden Ansprüche ausgebildetes Traggehäuse (1) zum Aufnehmen von technischen Ausrüstungsgegenständen, umfassend eine Vielzahl an Gehäusekorpussen (100), die sich im Hinblick auf eine Breite (B) nach dem 19"-Rastermaß gemäß DIN EN 60297-₃-100 oder EIA-₃10-E oder nach dem halb 19"-Rastermaß, eine Höheneinheitsabmessung (H) und/oder eine Nenntiefe (T) unterscheiden, eine Vielzahl von jeweils an eine Gesamtabmessung eines Gehäusekorpus (100) angepasste Schwingrahmen (200) zum Aufnehmen je wenigstens eines technischen Ausrüstungsgeräts und eine Vielzahl von Lagern (20) zum Abstützen der Schwingrahmen (200) in dem Gehäusekorpus (100), die sich im Hinblick auf eine relative elastische Schwingfähigkeit des Schwingrahmens (200) gegenüber dem Gehäusekorpus (100), eine Befestigungsschnittstelle zum Verbinden mit dem Gehäusekorpus (1009 und/oder dem Schwingrahmen (200) und/oder dem Bauraumbedarf voneinander unterscheiden, wobei zum Bilden eines Traggehäuses (1) ein Gehäusekorpus (100), wenigstens ein Schwingrahmen (200) und wenigstens ein Lager (20) kombiniert wird.

13. Baukastensystem nach Anspruch 12, wobei eine Vielzahl von Vormontageeinheiten dadurch bereitgestellt sind, dass je ein Schwingrahmen (200) und mindestens ein Lager (20) vormontiert sind.
